# EUROPEAN PATENT APPLICATION

(11) **EP 4 510 186 A1**
(43) Date of publication of application: **19.02.2025**
(21) Application number: 24168505.6
(22) Date of filing: 04.04.2024
(51) Int. Cl.: H01L 25/065, H01L 23/498, H01L 23/538, H01L 25/10, H01L 25/18

(54) **SEMICONDUCTOR PACKAGE AND INTEGRATED CIRCUIT DEVICE**

(30) Priority: 14.08.2023 KR 20230106375
(71) Applicant: Samsung Electronics Co., Ltd., Suwon-si, Gyeonggi-do 16677 (KR)
(72) Inventor: YU, Bong Wee, 16677 Suwon-si (KR); KIM, Chang Soo, 16677 Suwon-si (KR); JEON, Byung Chul, 16677 Suwon-si (KR); HUH, Jun Ho, 16677 Suwon-si (KR)
(74) Representative: Marks & Clerk LLP

(57) **Abstract**

A semiconductor package is provided. The semiconductor package comprises a package substrate, a first semiconductor chip on the package substrate, a second semiconductor chip spaced apart from the first semiconductor chip on the package substrate, and a bridge die placed below the first semiconductor chip and the second semiconductor chip on the package substrate, wherein the bridge die includes a first face that faces the first semiconductor chip and the second semiconductor chip, a second face that faces the package substrate, a connection wiring structure which is placed on the first face, and connects the first semiconductor chip and the second semiconductor chip, and a power wiring structure which is placed on the second face, and provides power to the first semiconductor chip and the second semiconductor chip.

## Description

### BACKGROUND

The present inventive concepts relate to semiconductor packages and integrated circuit devices.

In response to the rapid development of the electronic industry and user's demands, electronic devices are becoming smaller, lighter, and more multifunctional, and semiconductor packages used in the electric devices are also required to become smaller, lighter, and more multifunctional. To this end, by incorporating two or more types of semiconductor chips into one semiconductor package, it has become possible to provide high capacity and multifunction of the semiconductor package, while significantly reducing the size of the semiconductor package.

### SUMMARY

Aspects of the present inventive concepts provide semiconductor packages having improved product reliability.

Aspects of the present inventive concepts also provide integrated circuit devices having improved product reliability.

However, aspects of the present inventive concepts are not restricted to those set forth herein. The above and other aspects of the present inventive concepts will become more apparent to one of ordinary skill in the art to which the present inventive concepts pertain by referencing the detailed description of the present inventive concepts given below.

According to some aspects of the present inventive concepts, there is provided a semiconductor package comprises a package substrate, a first semiconductor chip on the package substrate, a second semiconductor chip spaced apart from the first semiconductor chip on the package substrate, and a bridge die below the first semiconductor chip and the second semiconductor chip on the package substrate, wherein the bridge die includes a first face that faces the first semiconductor chip and the second semiconductor chip, a second face that faces the package substrate, a connection wiring structure on the first face, and connects the first semiconductor chip and the second semiconductor chip, and a power wiring structure on the second face, and configured to provide power to the first semiconductor chip and the second semiconductor chip.

According to some aspects of the present inventive concepts, there is provided a semiconductor package comprises a package substrate, a first semiconductor chip on the package substrate, and includes a first power bump on a first lower face that faces the package substrate, a second semiconductor chip which is spaced apart from the first semiconductor chip on the package substrate, and includes a second power bump on a second lower face that faces the package substrate, and a bridge die below the first semiconductor chip and the second semiconductor chip on the package substrate, and connects the first semiconductor chip and the second semiconductor chip, wherein the bridge die includes a connection wiring structure on a first face that faces the first semiconductor chip and the second semiconductor chip, and connects the first semiconductor chip and the second semiconductor chip, a power wiring structure on a second face that faces the package substrate, and is spaced apart from the connection wiring structure, and a substrate between the connection wiring structure and the power wiring structure, wherein the package substrate includes a power ball on a lower face of the package substrate and connected to the power wiring structure, and the power wiring structure is connected to the first power bump and the second power bump.

According to some aspects of the present inventive concepts, there is provided a semiconductor package comprises a package substrate, a first semiconductor chip on the package substrate, and includes a first power bump on a first lower face that faces the package substrate, a second semiconductor chip which is spaced apart from the first semiconductor chip on the package substrate, and includes a second power bump on a second lower face that faces the package substrate, and a bridge die below the first semiconductor chip and the second semiconductor chip on the package substrate, and connects the first semiconductor chip and the second semiconductor chip, wherein the bridge die includes a connection wiring structure on a first face that faces the first semiconductor chip and the second semiconductor chip, and connects the first semiconductor chip and the second semiconductor chip, a connection bump between the connection wiring structure and the first semiconductor chip, and between the connection wiring structure and the second semiconductor chip, a power wiring structure on a second face that faces the package substrate, and is not connected to the connection wiring structure, a substrate between the connection wiring structure and the power wiring structure, and a third power bump between the power wiring structure and the package substrate, wherein the third power bump is connected to the first power bump and the second power bump, and a width of the bridge die is smaller than a width of the first semiconductor chip and a width of the second semiconductor chip.

According to some aspects of the present inventive concepts, there is provided an integrated circuit device comprises a package substrate, a first semiconductor chip on the package substrate, a second semiconductor chip spaced apart from the first semiconductor chip on the package substrate, and a bridge die on the package substrate and between the first semiconductor chip and the second semiconductor chip, wherein the bridge die includes a first face that faces the first semiconductor chip and the second semiconductor chip, a second face that faces the package substrate, a connection wiring structure on the first face, and connects the first semiconductor chip and the second semiconductor chip, and a power wiring structure on the second face, and is configured to supply power to the first semiconductor chip and the second semiconductor chip, wherein a level of signal provided to the connection wiring structure is smaller than a level of signal provided to the power wiring structure.

At least some of the above and other features of the invention are set out in the claims.

### BRIEF DESCRIPTION OF THE DRAWINGS

The above and other aspects and features of the present inventive concepts will become more apparent by describing in detail some example embodiments thereof with reference to the attached drawings, in which:
FIG. 1 is an example layout diagram for explaining a semiconductor package according to some example embodiments;
FIG. 2 is a schematic cross-sectional view taken along line A-A of FIG. 1;
FIG. 3 is an enlarged view showing a portion P of FIG. 2;
FIGS. 4 and 5 are diagrams for explaining the operation of an integrated circuit device according to some example embodiments;
FIG. 6 is a diagram for explaining a semiconductor package according to some example embodiments; and
FIGS. 7 to 15 are diagrams for explaining a semiconductor package according to some example embodiments.

### DETAILED DESCRIPTION

Hereinafter, example embodiments according to the technical idea of the present inventive concepts will be described with reference to the accompanying drawings.

In order to clearly describe the present inventive concepts, parts or portions that are irrelevant to the description are omitted, and identical or similar constituent elements throughout the specification are denoted by the same reference numerals.

Further, in the drawings, the size and thickness of each element are arbitrarily illustrated for ease of description, and the present inventive concepts are not necessarily limited to those illustrated in the drawings.

Throughout the specification, when a part is "connected" to another part, it includes not only a case where the part is "directly connected" but also a case where the part is "indirectly connected" with another part in between.

It will be understood that when an element such as a layer, film, region, area, or substrate is referred to as being "on" or "above" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

The terms "upper", "middle", "lower" may refer to relative positions along a particular direction (e.g. a vertical direction). Various directions (e.g. vertical direction, horizontal direction, etc.) may be defined relative to the structure of the devices described herein. It will be appreciated that these directions do not necessarily imply any particular orientation of the device in use.

As used herein, the singular forms "a", "an", and "the" are intended to include the plural forms as well, unless the context clearly indicates otherwise. Additionally, the description may be specific to a portion of the semiconductor package and the described structure may be repeated in other portions of the semiconductor package. For example, the described structure may be an individual element of an array of elements forming the semiconductor package. Accordingly, where the structure of a single element of a plurality of elements has been described, this structure may equally apply to other elements of the plurality of elements.

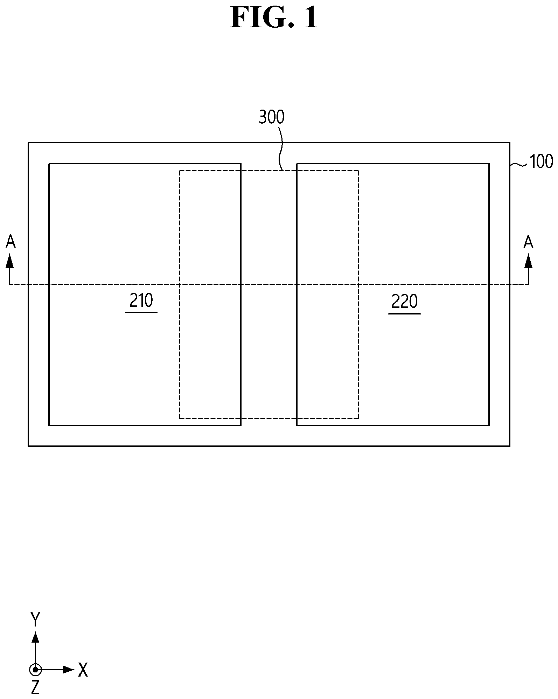

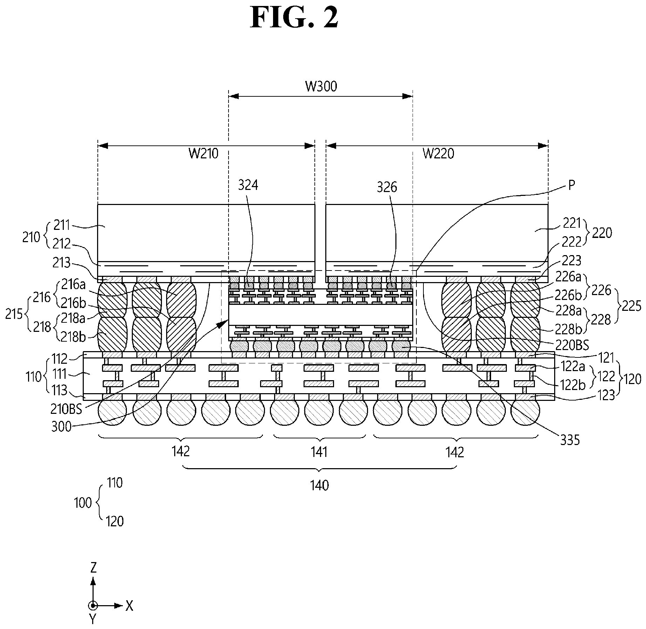

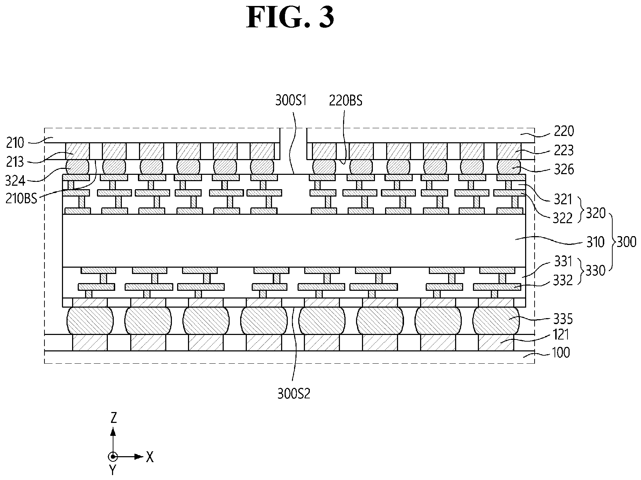

FIG. 1 is an example layout diagram for explaining a semiconductor package according to some example embodiments. FIG. 2 is a schematic cross-sectional view taken along line A-A of FIG. 1. FIG. 3 is an enlarged view showing a portion P of FIG. 2.

Referring to FIGS. 1 to 3, the semiconductor package according to some example embodiments may include a package substrate 100, a first semiconductor chip 210, a second semiconductor chip 220, and a bridge die 300. The semiconductor package according to some example embodiments may refer to an integrated circuit device.

The package substrate 100 may be a wiring structure for package. For example, the package substrate 100 may be a printed circuit wiring structure (PCB), a ceramic wiring structure, or the like. Alternatively, it goes without saying that the package substrate 100 may be a wiring structure for a wafer level package (WLP) fabricated at a wafer level. The package substrate 100 may include a lower face and an upper face that are opposite to each other.

The package substrate 100 may include a first insulating layer 110 and a package wiring structure 120. The first insulating layer 110 may include a first substrate 111, a first lower passivation film 113, and a first upper passivation film 112. The package wiring structure 120 may include a first lower pad 123, a first wiring 122, and a first upper pad 121.

The first substrate 111 may be, for example, a printed circuit substrate (PCB) or a ceramic substrate. However, the technical idea of the present inventive concepts is not limited thereto.

When the first substrate 111 is a printed circuit board, the first insulating layer 110 may be made up of at least one material selected from phenol resin, epoxy resin, and/or polyimide. The first insulating layer 110 may include, for example, at least one material selected from FR-4, tetrafunctional epoxy, polyphenylene ether, epoxy/polyphenylene oxide, BT (bismaleimide triazine), thermount, cyanate ester, polyimide, and/or liquid crystal polymer. A surface of the first substrate 111 may be covered with solder resist. That is, the first lower passivation film 113 and/or the first upper passivation film 112 formed on the surface of the first substrate 111 may be solder resist. However, the technical idea of the present inventive concepts is not limited thereto.

The package wiring structure 120 may be placed inside the first insulating layer 110. The package wiring structure 120 may be made up of the first wiring 122 for electrically connecting the first lower pad 123 and the first upper pad 121. The first wiring 122 may include a plurality of wiring patterns 122a, and a plurality of vias 122b for connecting each wiring.

Although the first substrate 111 is shown to be a single layer, this is only for convenience of explanation. For example, it goes without saying that the first substrate 111 may be made up of multiple layers to form the first wiring 122 of multiple layers.

In some example embodiments, an external connection terminal 140 may be formed on the lower face of the package substrate 100. The external connection terminal 140 may be attached to the first lower pad 123. The external connection terminal 140 may have, for example, but not limited to, a spherical shape or an ellipsoidal shape.

The external connection terminal 140 may electrically connect the package wiring structure 120 to an external device. Accordingly, the external connection terminal 140 may provide an electrical signal to the package wiring structure 120 or may provide an electrical signal, which is provided from the package wiring structure 120, to the external device.

The external connection terminal 140 may include a power ball 141 (e.g. one or more power balls) and a signal ball 142 (e.g. one or more signal balls). The power ball 141 and the signal ball 142 may be spaced apart from each other. The power ball 141 may be placed to overlap the bridge die 300. The signal ball 142 may not overlap the bridge die 300.

The power ball 141 may provide power, which is provided to the first semiconductor chip 210 and the second semiconductor chip 220, to the power wiring structure 330. The power ball 141 may be electrically connected to the power wiring structure 330 of the bridge die 300. The power ball 141 may be electrically connected to the power wiring structure 330 through the first wiring 122.

The signal ball 142 may provide signals to be input to the first semiconductor chip 210 and the second semiconductor chip 220. The signal ball 142 may receive signals that are output from the first semiconductor chip 210 and the second semiconductor chip 220. The signal ball 142 may be connected to a first chip bump 215 (e.g. one or more first chip bumps) and a second chip bump 225 (e.g. one or more second chip bumps). Respective ones of a plurality of signal balls 142 may be connected to respective ones of a plurality of first chip bumps 215 and/or second chip bumps 225. The signal ball 142 may be connected to the first chip bump 215 and the second chip bump 225 through the first wiring 122. The signal ball 142 may send and receive signals to and from the first semiconductor chip 210 and the second semiconductor chip 220 through the first chip bump 215 and the second chip bump 225.

The external connection terminals 140 may include, for example, at least one of tin (Sn), indium (In), lead (Pb), zinc (Zn), nickel (Ni), gold (Au), silver (Ag), copper (Cu), antimony (Sb), bismuth (Bi), and/or a combination thereof, but the technical idea of the present inventive concepts is not limited thereto.

The first semiconductor chip 210 and the second semiconductor chip 220 may be placed on the package substrate 100. The first semiconductor chip 210 and the second semiconductor chip 220 may be placed on the bridge die 300. That is to say, the first semiconductor chip 210 and the second semiconductor chip 220 may each overlap the bridge die 300 in a vertical direction (for example a Z-direction as depicted in FIG. 2). The vertical direction may be a direction perpendicular to one or more (e.g. each) of the first semiconductor chip 210, the second semiconductor chip 220 and the bridge die 300. The vertical direction (e.g. the Z-direction) may define a height direction for the semiconductor package. Accordingly, features that are described as "above" other features may be located further along the vertical direction than the other features. Similarly, "upper" portions of certain components may be above "lower" portions those components. The first semiconductor chip 210 and the second semiconductor chip 220 may be spaced apart from each other (e.g. in a horizontal direction perpendicular to the vertical direction, such as the X-direction as depicted in FIG. 2).

The first semiconductor chip 210 and the second semiconductor chip 220 may each be placed to overlap a part of the bridge die 300. The first semiconductor chip 210 and the second semiconductor chip 220 may be connected through a connection wiring structure 320 of the bridge die 300. The first semiconductor chip 210 and the second semiconductor chip 220 may send and receive signals to each other through the connection wiring structure 320.

The first semiconductor chip 210 and the second semiconductor chip 230 may each be an integrated circuit (IC) in which hundreds to millions of semiconductor elements are integrated in a single chip. For example, the first semiconductor chip 210 and the second semiconductor chip 220 may each include, for example, but not limited to, an application processor (AP) chip, such as a microprocessor and a microcontroller, a CPU (central processing unit), a modem, a logic chip such as an ASIC (application-specific IC) and an FPGA (field programmable gate array), or volatile memory chip such as a DRAM (dynamic random access memory) or a SRAM (static random access memory), a non-volatile memory chip such as a PRAM (phase-change Random Access Memory), a MRAM (Magnetoresistive Random Access Memory), a FeRAM (Ferroelectric Random Access Memory), and a RRAM (Resistive Random Access Memory), a flash memory or a HBM (high bandwidth memory), or a combination thereof.

In some example embodiments, the first semiconductor chip 210 and the second semiconductor chip 220 may be different types of semiconductor chips. As an example, the first semiconductor chip 210 may be an application processor chip or a logic chip, and the second semiconductor chip 220 may be a memory chip.

The first semiconductor chip 210 may include a first semiconductor substrate 211 and a first wiring structure 212, and the second semiconductor chip 220 may include a second semiconductor substrate 221 and a second wiring structure 222.

The first semiconductor substrate 211 and the second semiconductor substrate 221 may each be a bulk silicon or an SOI (silicon-on-insulator). In contrast, the first semiconductor substrate 211 and the second semiconductor substrate 221 may each be a silicon substrate, or may include other materials, for example, silicon germanium, SGOI (silicon germanium on insulator), indium antimonide, lead tellurium, indium arsenide, indium phosphide, gallium arsenide or gallium antimonide. Alternatively, the first semiconductor substrate 211 and the second semiconductor substrate 221 may each have an epitaxial layer formed on a base substrate.

The first wiring structure 212 may be formed on the first semiconductor substrate 211. The second wiring structure 222 may be formed on the second semiconductor substrate 221. The first wiring structure 212 and the second wiring structure 222 may each include wiring patterns of multilayers, and insulating layers for mutually insulating the wiring patterns of the multilayers.

A plurality of circuit elements may be formed on each of the first semiconductor substrate 211 and the second semiconductor substrate 221. The first wiring structure 212 may be electrically connected to the circuit elements on the first semiconductor substrate 211, and the second wiring structure 222 may be electrically connected to the circuit elements on the second semiconductor substrate 221.

The first semiconductor chip 210 may include a first chip pad 213. The first chip pad 213 may be used to electrically connect the first semiconductor chip 210 to other components. For example, the first chip pad 213 may be electrically connected to the first wiring structure 212. The first chip pad 213 may be exposed from the lower face of the first wiring structure 212.

The second semiconductor chip 220 may include a second chip pad 223. The second chip pad 223 may be used to electrically connect the second semiconductor chip 220 to other components. For example, the second chip pad 223 may be electrically connected to the second wiring structure 222. The second chip pad 223 may be exposed from the lower face of the second wiring structure 222.

The first chip pad 213 and the second chip pad 223 may each include a conductive material, for example, but not limited to, copper (Cu), aluminum (Al), silver (Ag), tin (Sn), gold (Au), nickel (Ni), lead (Pb), titanium (Ti), alloys thereof, and/or the like.

The first chip pad 213 may be in contact, or direct contact, with the first chip bump 215 and the first connection bump 324. The first chip pad 213 may be connected to the first chip bump 215 and the first connection bump 324. The first chip pad 213 may electrically connect the first chip bump 215 and the first wiring structure 212. The first chip pad 213 may electrically connect the first connection bump 324 and the first wiring structure 212. The first chip pad 213 may electrically connect the first semiconductor chip 210 to the connection wiring structure 320 through the first connection bump 324.

The second chip pad 223 may be in contact, or direct contact, with the second chip bump 225 and a second connection bump 326. The second chip pad 223 may be connected to the second chip bump 225 and the second connection bump 326. The second chip pad 223 may electrically connect the second chip bump 225 and the second wiring structure 222. The second chip pad 223 may electrically connect the second connection bump 326 and the second wiring structure 222. The second chip pad 223 may electrically connect the second semiconductor chip 220 to the connection wiring structure 320 through the second connection bump 326.

The first chip bump 215 may be formed on the lower face of the first chip pad 213. The first chip bump 215 may connect the first chip pad 213 and the package wiring structure 120. That is, the first semiconductor chip 210 may be electrically connected to the package substrate 100 through the first chip bump 215 and the first chip pad 213. The first semiconductor chip 210 may send and receive electrical signals to and from the package substrate 100 through the first chip bump 215 and the first chip pad 213.

The first chip bump 215 may include a first power bump 216 (e.g. one or more first power bumps) and a first signal bump 218 (e.g. one or more first signal bumps). The first semiconductor chip 210 may receive power through the first power bump 216. The first semiconductor chip 210 may receive or output signal through the first signal bump 218.

The first power bump 216 and the first signal bump 218 may be spaced apart from each other. For example, the first signal bump 218 may be located outside the first power bump 216. However, the example embodiments are not limited thereto. For example, the first power bump 216 may be placed outside the first signal bump 218.

The first power bump 216 may be placed to be closer to the bridge die 300 than the first signal bump 218. For example, the first power bump 216 may be placed on the inner side than the first signal bump 218. A distance between the power wiring structure 330 and the first power bump 216 of the bridge die 300 may be smaller than a distance between the power wiring structure 330 and the first signal bump 218.

The first power bump 216 and the first signal bump 218 may be in contact, or direct contact, with the first chip pad 213 and the first upper pad 121. The first power bump 216 and the first signal bump 218 may be electrically connected to the first wiring structure 212 of the first semiconductor chip 210 through the first chip pad 213. The first power bump 216 and the first signal bump 218 may be electrically connected to the package wiring structure 120 through the first upper pad 121.

The first power bump 216 may be electrically connected to the power wiring structure 330. Specifically, the first power bump 216 may be connected to a bridge power bump 335 (described below) through the package wiring structure 120 of the package substrate 100. That is, the first semiconductor chip 210 and the power wiring structure 330 may be electrically connected through the first power bump 216, the package wiring structure 120, and the bridge power bump 335.

The first signal bump 218 may be electrically connected to the connection wiring structure 320. Specifically, the first signal bumps 218 may be connected to the first connection bump 324 through the first wiring structure 212 of the first semiconductor chip 210. That is, the package substrate 100 and the connection wiring structure 320 may be electrically connected through the first signal bump 218, the first wiring structure 212 and the first connection bump 324.

The first power bump 216 may include a first upper power bump 216a and a first lower power bump 216b. The first signal bump 218 may include a first upper signal bump 218a and a first lower signal bump 218b. The first upper power bump 216a and the first upper signal bump 218a may be in contact, or direct contact, with the first chip pad 213. The first lower power bump 216b and the first lower signal bump 218b may be in contact, or direct contact, with the first upper pad 121.

The second chip bump 225 may be formed on the lower face of the second chip pad 223. The second chip bump 225 may connect the second chip pad 223 and the package wiring structure 120. That is, the second semiconductor chip 220 may be electrically connected to the package substrate 100 through the second chip bump 225 and the second chip pad 223. The second semiconductor chip 220 may send and receive signals to and from the package substrate 100 through the second chip bump 225 and the second chip pad 223.

The second chip bump 225 may include a second power bump 226 (e.g. one or more second power bumps) and a second signal bump 228 (e.g. one or more second signal bumps). The second semiconductor chip 220 may receive power through the second power bump 226. The second semiconductor chip 220 may receive or output the signal through the second signal bump 228.

The second power bump 226 and the second signal bump 228 may be spaced apart from each other. For example, the second signal bump 228 may be placed on the outer side than the second power bump 226. However, the example embodiments are not limited thereto. For example, the second power bump 226 may be placed on the outer side than the first signal bump 228.

The second power bump 226 may be placed to be closer to the bridge die 300 than the second signal bump 228. For example, the second power bump 226 may be placed on the inner side than the second signal bump 228. A distance between the power wiring structure 330 of the bridge die 300 and the second power bumps 226 may be smaller than a distance between the power wiring structure 330 and the second signal bump 228.

The second power bump 226 and the second signal bump 228 may be in contact, or direct contact, with the second chip pad 223 and the first upper pad 121, respectively. The second power bump 226 and the second signal bump 228 may be electrically connected to the second wiring structure 222 of the second semiconductor chip 220 through the second chip pad 223. The second power bump 226 and the second signal bump 228 may be electrically connected to the package wiring structure 120 through the first upper pad 121.

The second power bump 226 may be electrically connected to the power wiring structure 330. Specifically, the second power bump 226 may be connected to the bridge power bump 335 through the package wiring structure 120 of the package substrate 100. That is, the second semiconductor chip 220 and the power wiring structure 330 may be electrically connected through the second power bump 226, the package wiring structure 120 and the bridge power bump 335.

The second signal bump 228 may be electrically connected to the connection wiring structure 320. Specifically, the second signal bump 228 may be connected to the second connection bump 326 through the second wiring structure 222 of the second semiconductor chip 220. That is, the package substrate 100 and the connection wiring structure 320 may be electrically connected through the second signal bump 228, the second wiring structure 222, and the second connection bump 326.

The second power bumps 226 may include a second upper power bump 226a and a second lower power bump 226b. The second signal bump 228 may include a second upper signal bump 228a and a second lower signal bump 228b. The second upper power bump 226a and the second upper signal bump 228a may be in contact, or direct contact, with the second chip pad 223. The second lower power bump 226b and the second lower signal bump 228b may be in contact, or direct contact, with the first upper pad 121.

Sizes of the first chip bump 215 and the second chip bump 225 may be greater than the size of the bridge power bump 335. Sizes of the first power bump 216, the first signal bump 218, the second power bump 226, and the second signal bump 228 may be greater than the size of the bridge power bump 335. For example, the widths of the first chip bump 215 and the second chip bump 225 may be greater than the width of the bridge power bump 335. The heights of the first chip bump 215 and the second chip bump 225 may be greater than the height of the bridge power bump 335.

For example, the sizes of the first upper power bump 216a, the first lower power bump 216b, the first upper signal bump 218a, and the first lower signal bump 218b may each be greater than the size of the bridge power bump 335. As another example embodiment, the sizes of each of the first upper power bump 216a and the first lower power bump 216b are smaller than the size of the bridge power bump 335, but the overall size of the first power bump 216 may be greater than the size of the bridge power bump 335. Although in some example embodiments the sizes of each of the first upper signal bump 218a and the first lower signal bump 218b may be smaller than the size of the bridge power bump 335, the overall size of the first signal bump 218 may be greater than the size of the bridge power bump 335.

Similarly, the sizes of the second upper power bump 226a, the second lower power bump 226b, the second upper signal bump 228a, and the second lower signal bump 228b may each be greater than the size of the bridge power bump 335. In contrast, in some example embodiments the sizes of each of the second upper power bump 226a and the second lower power bump 226b are smaller than the size of the bridge power bump 335, but the overall size of the second power bump 226 may be greater than the size of the bridge power bump 335. Although in some example embodiments the sizes of each of the second upper signal bump 228a and the second lower signal bump 228b may be smaller than the size of the bridge power bump 335, the overall size of the second signal bump 228 may be greater than the size of the bridge power bump 335.

The first chip bump 215 and the second chip bump 225 may each be, for example, but not limited to, a solder bump. As described herein, a "bump" may be a contact that is configured to provide connection between a package (e.g. package substrate 100) and a chip or die, or between two chips or dies. Needless to say, the number, interval, placement form, and the like of each of the first chip bumps 215 and the second chip bumps 225 are not limited to those shown in the drawings, and may vary depending on the design.

The bridge die 300 may be placed on the package substrate 100. The bridge die 300 may be placed on the lower faces of the first semiconductor chip 210 and the second semiconductor chip 220. The bridge die 300 may overlap the power ball 141.

The bridge die 300 may be placed between the first semiconductor chip 210 and the second semiconductor chip 220. Specifically, the bridge die 300 may overlap a part of the first semiconductor chip 210 and a part of the second semiconductor chip 220. The bridge die 300 may overlap a space in which the first semiconductor chip 210 and the second semiconductor chip 220 are spaced apart from each other. A width W300 of the bridge die may be smaller than a width W210 of the first semiconductor chip and a width W220 of the second semiconductor chip. The widths W300 and W210 may be measured along a horizontal direction (e.g. the X-direction).

The bridge die 300 may include a separate substrate 310, a connection wiring structure 320, and a power wiring structure 330.

The bridge die 300 may include a first face 300S1 that faces the lower face 210BS of the first semiconductor chip and the lower face 220BS of the second semiconductor chip. The bridge die 300 may include a second face 300S2 that faces the package substrate 100.

The bridge die 300 may include a connection wiring structure 320 on the first face 3 00 S1. The connection wiring structure 320 may include a first face 300S1. The connection wiring structure 320 may be opposite to the lower face 210BS of the first semiconductor chip and the lower face 220BS of the second semiconductor chip. The connection wiring structure 320 may include a second insulating layer 321 and a connection wiring 322.

The bridge die 300 may include a power wiring structure 330 on the second face 300S2. The power wiring structure 330 may include a second face 300S2. The power wiring structure 330 may be opposite to the package substrate 100. The power wiring structure 330 may include a third insulating layer 331 and a power wiring 332.

The connection wiring structure 320 and the power wiring structure 330 may be spaced apart from each other with the separation substrate 310 interposed therebetween. The connection wiring structure 320 and the power wiring structure 330 may not be electrically connected to each other.

The separation substrate 310 may be placed between the first face 300S 1 and the second face 300S2. For example, the separation substrate 310 may be placed between the first face 300S1 and the second face 300S2 in a vertical direction. The separation substrate 310 may be placed between the connection wiring structure 320 and the power wiring structure 330. The separation substrate 310 may not electrically connect the connection wiring structure 320 and the power wiring structure 330. For example, the separation substrate 310 may insulate the connection wiring structure 320 from the power wiring structure 330. For example, the separation substrate 310 may not include a through via that connects the connection wiring structure 320 and the power wiring structure 330. The separation substrate 310 may be a bulk silicon.

The bridge die 300 may connect the first semiconductor chip 210 and the second semiconductor chip 220. Specifically, the connection wiring structure 320 of the bridge die 300 may connect the first semiconductor chip 210 and the second semiconductor chip 220. For example, the connection wiring structure 320 may provide signals output by the first semiconductor chip 210 to the second semiconductor chip 220. As another example, the connection wiring structure 320 may provide signal output by the second semiconductor chip 220 to the first semiconductor chip 210.

The bridge die 300 may include a first connection bump 324 (e.g. one or more first connection bumps) and a second connection bump 326 (e.g. one or more second connection bumps). The first connection bump 324 and the second connection bump 326 may be placed on the first face 300S1 of the bridge die 300. The first connection bump 324 may be placed between the first face 300S1 of the bridge die 300 and the lower face 210BS of the first semiconductor chip. The second connection bump 326 may be placed between the first face 300S1 of the bridge die 300 and the lower face 220BS of the second semiconductor chip.

The first connection bump 324 may be placed between the connection wiring structure 320 and the first semiconductor chip 210. The first connection bump 324 may be in contact, or direct contact, with the first chip pad 213. The second connection bump 326 may be placed between the connection wiring structure 320 and the second semiconductor chip 220. The second connection bump 326 may be in contact, or direct contact, with the second chip pad 223.

The connection wiring structure 320 may be connected to the first wiring structure 212 of the first semiconductor chip 210 through the first connection bump 324. The connection wiring structure 320 may send and receive electrical signals to and from the first semiconductor chip 210 through the first connection bump 324.

The connection wiring structure 320 may be connected to the first wiring structure 222 of the second semiconductor chip 220 through the second connection bump 326. The connection wiring structure 320 may send and receive electrical signals to and from the second semiconductor chip 220 through the second connection bump 326.

The bridge die 300 may include a bridge power bump 335 (e.g. one or more bridge power bumps). The bridge power bump 335 may be placed on the second face 300S2. The bridge power bump 335 may be placed between the second face 300S2 of the bridge die 300 and the upper face of the package substrate 100.

The bridge power bump 335 may be placed between the power wiring structure 330 and the package substrate 100. The bridge power bump 335 may be in contact, or direct contact, with the first upper pad 121.

The bridge power bump 335 may electrically connect the power wiring structure 330 and the package substrate 100.

For example, the power wiring structure 330 may be connected to the package wiring structure 120 of the package substrate 100 through the bridge power bump 335. The power wiring structure 330 may receive power from the package wiring structure 120 through the bridge power bump 335.

The bridge power bump 335 may electrically connect the power wiring structure 330, the first semiconductor chip 210, and the second semiconductor chip 220.

For example, the first semiconductor chip 210 and the second semiconductor chip 220 may be connected to the power wiring structure 330 through the bridge power bump 335. Specifically, the first power bump 216 and the second power bump 226 may be connected to the power wiring structure 330 through the bridge power bump 335 and the package wiring structure 120. Therefore, the first semiconductor chip 210 may be provided with power through the first power bump 216, the package wiring structure 120, the bridge power bump 335, and the power wiring structure 330. Further, the second semiconductor chip 220 may be supplied with power through the second power bump 226, the package wiring structure 120, the bridge power bump 335, and the power wiring structure 330.

The connection wiring structure 320 may provide a signal between the first semiconductor chip 210 and the second semiconductor chip 220. For example, the connection wiring structure 320 may transmit the signal output by the first semiconductor chip 210 to the second semiconductor chip 220. As another example, the connection wiring structure 320 may transmit the signal output by the second semiconductor chip 220 to the first semiconductor chip 210. The signal provided by the connection wiring structure 320 to the first semiconductor chip 210 and the second semiconductor chip 220 may have a lower level than the signal provided by the power wiring structure 330 to the first semiconductor chip 210 and the second semiconductor chip 220. That is, power wiring structure 330 may be configured to support (e.g. transfer or output) signals having a higher level (e.g. higher voltage or current) than signals supported (e.g. transferred or output) by the connection wiring structure 320. For instance, a maximum signal that may be output by the power wiring structure 330 may be greater than a maximum signal that may be output by the connection wiring structure 320. A maximum signal supported by a given wiring structure may be a maximum signal (e.g. maximum voltage) that may be applied across the wiring structure (e.g. across a portion of the wiring structure) without damage to the wiring structure (e.g. through dielectric breakdown).

The power wiring structure 330 may include a power integrated circuit (power IC) for providing the power signal to the first semiconductor chip 210 and the second semiconductor chip 220. For example, the power wiring structure 330 may provide power to the first semiconductor chip 210. As another example, the power wiring structure 330 may provide the power to the second semiconductor chip 220. The level of power provided by the power wiring structure 330 to the first semiconductor chip 210 and the second semiconductor chip 220 may be greater than the level of signal provided by the connection wiring structure 320 to the first semiconductor chip 210 and the second semiconductor chip 220.

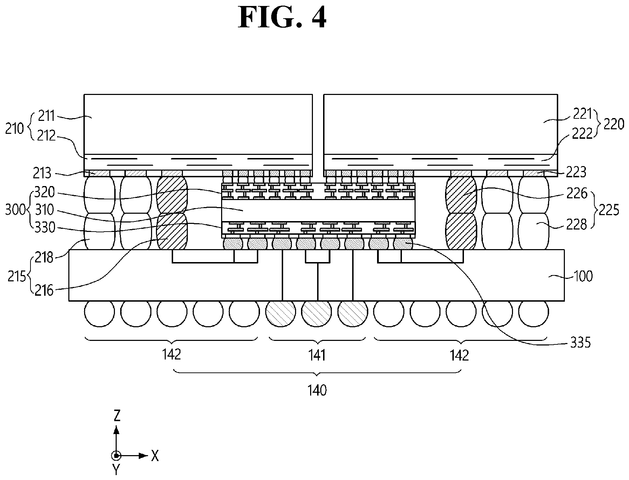

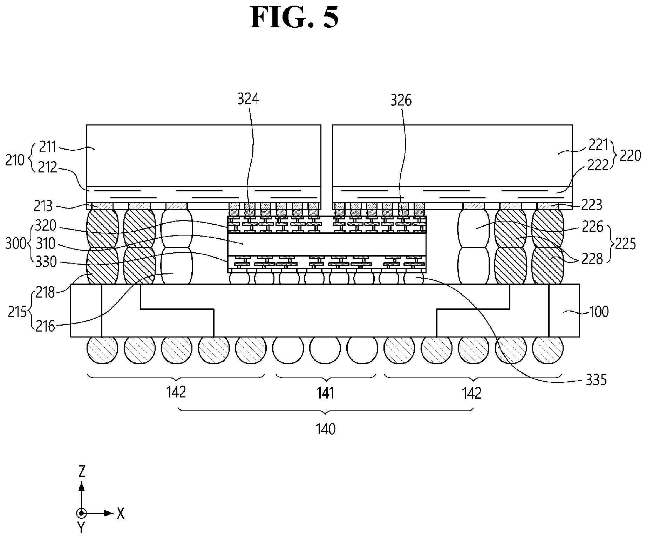

FIGS. 4 and 5 are diagrams for explaining the operation of an integrated circuit device according to some example embodiments. For reference, FIG. 4 is a diagram for explaining an operation in which power is provided to the first semiconductor chip 210 and the second semiconductor chip 200. FIG. 5 is a diagram for explaining the signal connection operation of the first semiconductor chip 210 and the second semiconductor chip 200.

Referring to FIG. 4, power may be supplied from the outside to the package substrate 100 through the power ball 141. The power ball 141 may provide power to the bridge power bump 335 (e.g. a first one or more bridge power bumps 335). The power provided to the power ball 141 may be provided to the power wiring structure 330 through the bridge power bump 335.

The power wiring structure 330 may include a structure for redistributing the power provided to the first semiconductor chip 210 and the second semiconductor chip 220. The power wiring structure 330 may provide power to the first semiconductor chip 210 through the bridge power bump 335 (e.g. a second one or more bridge power bumps 335) and the first power bump 216. The power wiring structure 330 may provide power to the second semiconductor chip 220 through the bridge power bump 335 (e.g. a third one or more bridge power bumps 335) and the second power bump 226.

Referring to FIG. 5, the first semiconductor chip 210 and the second semiconductor chip 220 may send and receive signals to and from the outside through the signal ball 142. Further, the first semiconductor chip 210 and the second semiconductor chip 220 may send and receive signals to and from each other through the connection wiring structure 320.

The signal ball 142 may receive the signal from the outside. The signal may be provided to the package substrate 100 from the outside through the signal ball 142. For example, the signal provided to the signal ball 142 may include commands regarding the operation of the first semiconductor chip 210 and the second semiconductor chip 220.

The signal ball 142 may provide the signal to the first signal bump 218 (e.g. a first input signal bump 218) and the second signal bump 228 (e.g. a second input signal bump 228). The first signal bump 218 and the second signal bump 228 may provide signals to the first wiring structure 212 of the first semiconductor chip 210 and the second wiring structure 222 of the second semiconductor chip 220, respectively.

The first semiconductor chip 210 and the second semiconductor chip 220 may output signals to the outside through the signal ball 142. The first semiconductor chip 210 may provide the signal to the package substrate 100 through the first signal bump 218 (e.g. a first output signal bump 218). The second semiconductor chip 220 may provide the signal to the package substrate 100 through the second signal bump 228 (e.g. a second output signal bump 228). The package substrate 100 may output signals, which are provided from the first semiconductor chip 210 and the second semiconductor chip 220, to the outside through the signal ball 142. For each of the first and second signal pumps, separate input and output signal pumps may be provided for input and output signals.

The first semiconductor chip 210 may provide the signal to the second semiconductor chip 220. Specifically, the first semiconductor chip 210 may provide signals to the connection wiring structure 320 through the first connection bump 324. The connection wiring structure 320 may provide signals to the second semiconductor chip 220 through the second connection bump 326.

Similarly, the second semiconductor chip 220 may provide signals to the first semiconductor chip 210. Specifically, the second semiconductor chip 220 may provide signals to the connection wiring structure 320 through the second connection bump 326. The connection wiring structure 320 may provide signals to the first semiconductor chip 210 through the first connection bump 324.

The connection wiring structure 320 may include a structure for rewiring signals provided to the first semiconductor chip 210 and the second semiconductor chip 220. The first semiconductor chip 210 and the second semiconductor chip 220 may directly send and receive signals through the connection wiring structure 320.

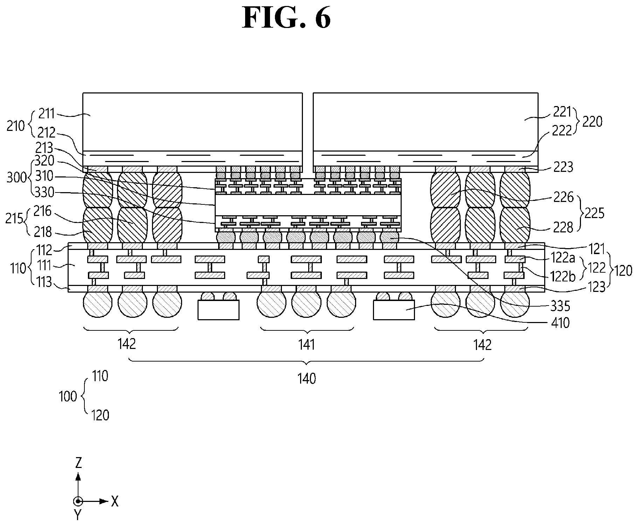

FIG. 6 is a diagram for explaining a semiconductor package according to some example embodiments. For convenience of explanation, the explanation will focus on the points that are different from those explained with reference to FIGS. 1 to 3.

Referring to FIG. 6, the semiconductor package according to some example embodiments may include a first passive element 410. For example, the first passive element 410 may be placed on the lower face of the package substrate 100. The first passive element 410 may be spaced apart from the external connection terminals 140 on the lower face of the package substrate 100.

Although the first passive element 410 is shown as being placed between the power ball 141 and the signal ball 142 in FIG. 6, the example embodiments are not limited thereto. For example, the first passive element 410 may be placed outside the signal ball 142, and may not be placed adjacent to the power ball 141. As another example, the first passive element 410 may be placed on the inner side than the power ball 141 and the signal ball 142, and placed between the plurality of power balls 141.

The first passive element 410 may include, for example, an inductor. The first passive element 410 may be used, when power is provided from the power ball 141 to the first semiconductor chip 210 and the second semiconductor chip 220 through the power wiring structure 330.

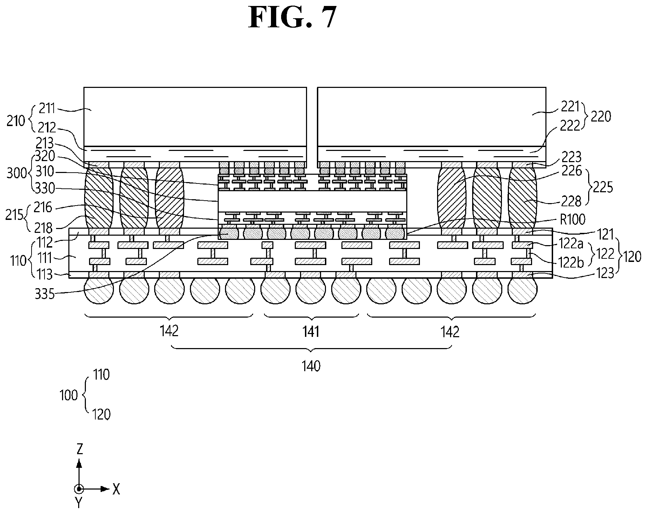

FIGS. 7 to 15 are diagrams for explaining a semiconductor package according to some example embodiments. For convenience of explanation, the explanation will focus on points that are different from those described with reference to FIGS. 1 to 6.

Referring to FIG. 7, the package substrate 100 may include a recess R100. A bridge power bump 335 may be placed inside the recess R100. For example, the lower face of the power wiring structure 330 may be placed on the same plane as the upper face of the package substrate 100. However, the example embodiments are not limited thereto.

Referring to FIG. 7 in comparison with FIG. 2, as the bridge power bump 335 is placed inside the recess R100, a distance between the package substrate 100, the first semiconductor chip 210, and the second semiconductor chip 220 may relatively decrease. Therefore, each of the first and second chip bumps 225 and 215 may be made up of a single bump, without including an upper bump and a lower bump. For example, the first power bump 216 may not include a first upper power bump (216a of FIG. 2) and a first lower power bump (216b of FIG. 2). The first signal bump 218 may not include a first upper signal bump (218a of FIG. 2) and a first lower signal bump 218b. The second power bump 226 may not include a second upper power bump (226a of FIG. 2) and a second lower power bump (226b of FIG. 2). The second signal bump 228 may not include a second upper signal bump (228a of FIG. 2) and a second lower signal bump (228b of FIG. 2).

Although FIG. 7 shows that only the bridge power bump 335 is placed inside the recess R100, the example embodiments are not limited thereto. For example, the bridge power bump 335 and the power wiring structure 330 may be placed inside the recess R100. In this case, the upper face of the package substrate 100 and the lower face of the separation substrate 310 may be placed on the same plane.

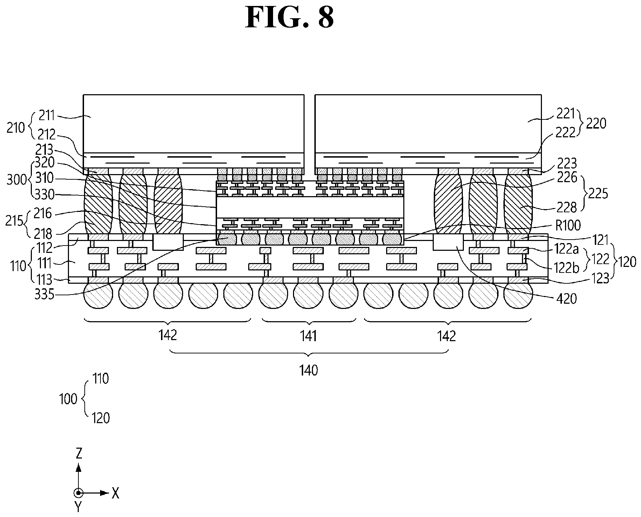

Referring to FIG. 8, the semiconductor package according to some example embodiments may include one or more silicon capacitors 420. The silicon capacitor(s) 420 may be placed inside the package substrate 100. The silicon capacitor 420 may be placed adjacent to the power wiring structure 330. For example, silicon capacitors 420 may be placed on the inner side than the first signal bump 218 and the second signal bump 228. Although the silicon capacitor 420 is shown as being connected to the first power bump 216 and the second power bump 226, the example embodiments are not limited thereto.

The silicon capacitor 420 may be used, when power is provided from the power ball 141 to the first semiconductor chip 210 and the second semiconductor chip 220 through the power wiring structure 330.

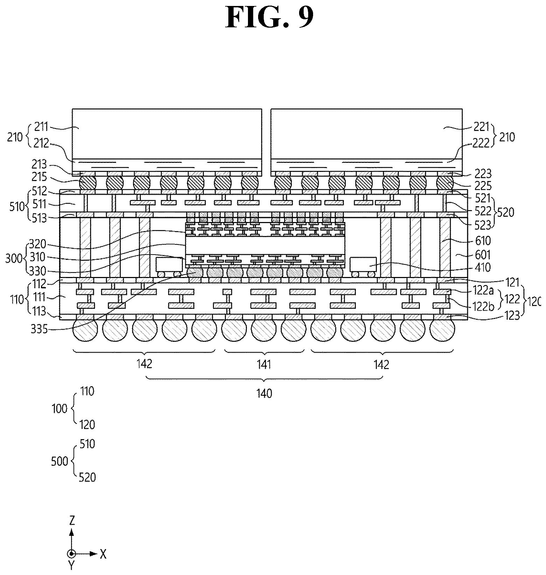

Referring to FIG. 9, a semiconductor package according to some example embodiments may include a first interposer 500.

A first interposer 500 may be placed on the bridge die 300. The first interposer 500 may be connected to the package substrate 100 through the first pillar structure 610. The first pillar structure 610 may pass through a first molding film 601. The first interposer 500 may be placed on the first molding film 601.

The bridge die 300 may be placed inside the first molding film 601. The first molding film 601 may surround the bridge die 300. The first molding film 601 may include, for example, but not limited to, an insulating polymer material such as an EMC (Epoxy Molding Compound).

The first passive element 410 may be placed inside the first molding film 601. The first passive element 410 may be placed between the first pillar structure 610 and the bridge die 300. The first passive component 410 may be placed to be closer to the bridge die 300 than the first pillar structure 610.

The first interposer 500 may include a fourth insulating layer 510 and a first interposer wiring 520. The fourth insulating layer 510 may include a second substrate 511, a second lower passivation film 513 and a second upper passivation film 512. The first interposer wiring 520 may include a second lower pad 523, a second wiring 522, and a second upper pad 521.

The first chip bumps 215 of the first semiconductor chip 210 and the second chip bumps 225 of the second semiconductor chip 220 may be placed on the first interposer 500. The first semiconductor chip 210 may be connected to the first interposer wiring 520 of the first interposer 500 through the first chip bump 215. The second semiconductor chip 220 may be connected to the first interposer wiring 520 of the first interposer 500 through the second chip bump 225.

The power ball 141 may provide power to the first semiconductor chip 210 and the second semiconductor chip 220 through the package wiring structure 120, the power wiring structure 330, the first pillar structure 610 and the first interposer wiring 520. For example, the power wiring structure 330 may redistribute the power provided from the power ball 141, and provide the power to the first semiconductor chip 210 and the second semiconductor chip 220 through the package wiring structure 120, the first pillar structure 610 and the first interposer wiring 520.

The first semiconductor chip 210 and the second semiconductor chip 220 may send and receive signals through the first interposer wiring 520 and the connection wiring structure 320. For example, signals output from the first semiconductor chip 210 may be provided to the connection wiring structure 320 through the first chip bump 215 and the first interposer wiring 520. The connection wiring structure 320 may provide signal, which is provided from the first semiconductor chip 210, to the second semiconductor chip 220 through the first interposer wiring 520 and the second chip bump 225. Similarly, the signal output from the second semiconductor chip 220 may be provided to the connection wiring structure 320 through the second chip bump 225 and the first interposer wiring 520. The connection wiring structure 320 may provide signal, which is provided from the second semiconductor chip 220, to the first semiconductor chip 210 through the first interposer wiring 520 and the first chip bump 215.

The first semiconductor chip 210 and the second semiconductor chip 220 may provide signal to the package substrate 100 through the first interposer wiring 520 and the first pillar structure 610. The first semiconductor chip 210 and the second semiconductor chip 220 may output signal to the first interposer wiring 520. The first interposer wiring 520 may provide signals, which are provided from the first semiconductor chip 210 and the second semiconductor chip 220, to the package substrate 100 through the first pillar structure 610.

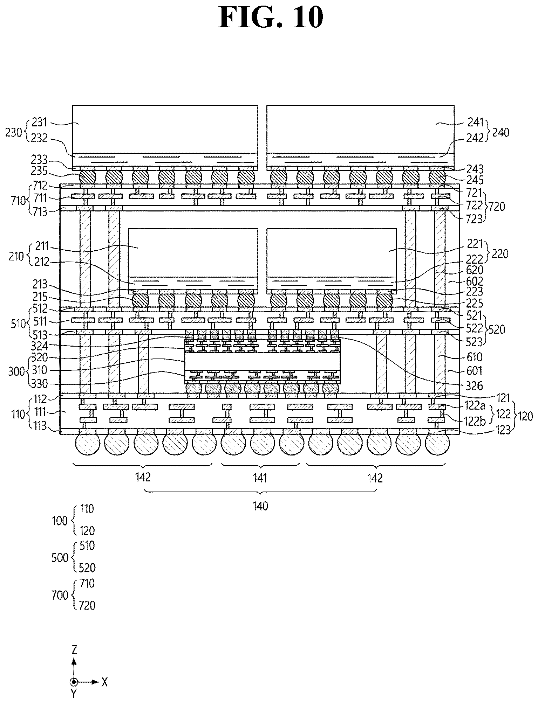

Referring to FIG. 10, the semiconductor package according to some example embodiments may include a third semiconductor chip 230, a fourth semiconductor chip 240, and a second interposer 700.

The first semiconductor chip 210 and the second semiconductor chip 220 may be placed inside a second molding film 602. The second molding film 602 may surround the first semiconductor chip 210 and the second semiconductor chip 220. The second molding film 602 may include, for example, but not limited to, an insulating polymer material such as an EMC (Epoxy Molding Compound).

A second interposer 700 may be placed on the first semiconductor chip 210 and the second semiconductor chip 220. The second interposer 700 may be placed on the second molding film 602. The second interposer 700 may include a fifth insulating layer 710 and a second interposer wiring 720. The fifth insulating layer 710 may include a third substrate 711, a third lower passivation film 713 and a third upper passivation film 712. The second interposer wiring 720 may include a third lower pad 723, a third wiring 722 and a third upper pad 721.

The third semiconductor chip 230 and the fourth semiconductor chip 240 may be placed on the second interposer 700. The third semiconductor chip 230 may include a third semiconductor substrate 231 and a third wiring structure 232 and the fourth semiconductor chip 240 may include a fourth semiconductor substrate 241 and a fourth wiring structure 242. The third semiconductor chip 230 may be connected to the second interposer wiring 720 of the second interposer 700 through the third chip bump 235. The fourth semiconductor chip 240 may be connected to the second interposer wiring 720 of the second interposer 700 through the fourth chip bump 245. The third semiconductor chip 230 and the fourth semiconductor chip 240 may include third chips pads 233 and fourth chip pads 243, respectively.

The second pillar structure 620 may pass through the second molding film 602. The second pillar structure 620 may extend from the first interposer 500 to the second interposer 700 inside the second molding film 602. The second pillar structure 620 may connect the first interposer wiring 520 of the first interposer 500 and the second interposer wiring 720 of the second interposer 700.

The third semiconductor chip 230 and the fourth semiconductor chip 240 may be provided with power through the package wiring structure 120, the power wiring structure 330, the first pillar structure 610, the first interposer 500, the second pillar structure 620, and the second interposer 700. However, example embodiments are not limited thereto. For example, the power wiring structure 330 may be used when providing power to the first semiconductor chip 210 and the second semiconductor chip 220, but may not be used when providing power to the third semiconductor chip 230 and the fourth semiconductor chip 240.

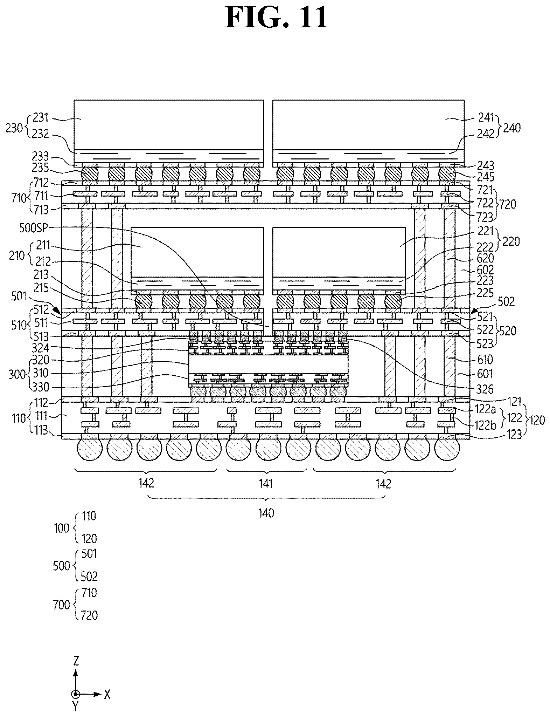

Referring to FIG. 11, the first interposer 500 may include a first sub-interposer 501 and a second sub-interposer 502.

A first separation space 500SP may be placed between the first sub-interposer 501 and the second sub-interposer 502. The second molding film 602 may fill the first separation space 500SP.

The first semiconductor chip 210 may be placed on the first sub-interposer 501. The second semiconductor chip 220 may be placed on the second sub-interposer 502.

The bridge die 300 may be placed over the first sub-interposer 501 and the second sub-interposer 502. The connection wiring structure 320 may be placed over the first sub-interposer 501 and the second sub-interposer 502. The connection wiring structure 320 may be placed to overlap a part of the first sub-interposer 501 and a part of the second sub-interposer 502.

The first connection bump 324 may be placed on the lower face of the first sub-interposer 501. The first connection bumps 324 may be connected to the second lower pad 523 of the first sub-interposer 501. The second connection bump 326 may be placed on the lower face of the second sub-interposer 502. The second connection bumps 326 may be connected to the second lower pad 523 of the second sub-interposer 502.

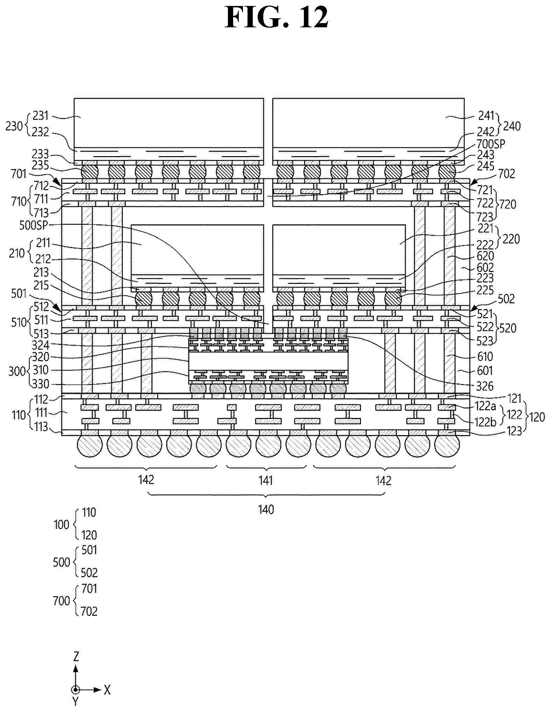

Referring to FIG. 12, the second interposer 700 may include a third sub-interposer 701 and a fourth sub-interposer 702.

A second separation space 700SP may be placed between the third sub-interposer 701 and the fourth sub-interposer 702. The second molding film 602 may fill the second separation space 700SP. The upper face of the second molding film 602 in the second separation space 700SP may be placed on the same plane as the upper face of the third sub-interposer 701 and the upper face of the fourth sub-interposer 702.

The third semiconductor chip 230 may be placed on the third sub-interposer 701. The fourth semiconductor chip 240 may be placed on the fourth sub-interposer 702. The third chip bump 235 of the third semiconductor chip 230 may be connected to the second interposer wiring 720 of the third sub-interposer 701. The fourth chip bump 245 of the fourth semiconductor chip 240 may be connected to the second interposer wiring 720 of the fourth sub-interposer 702.

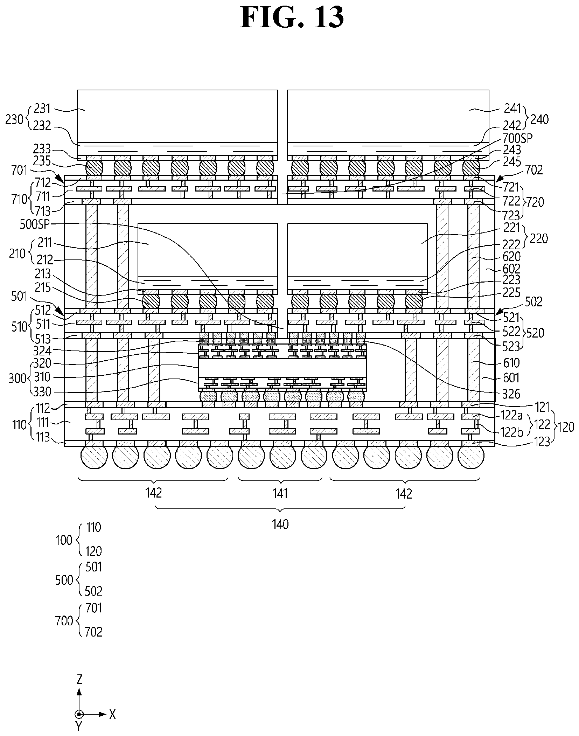

Referring to FIG. 13, a molding film may not be placed in the second separation space 700SP between the third sub-interposer 701 and the fourth sub-interposer 702. The second molding film 602 may be placed below the third sub-interposer 701 and the fourth sub-interposer 702. The upper face of the second molding film 602 may be placed on the same plane as the lower face of the third sub-interposer 701 and the lower face of the fourth sub-interposer 702.

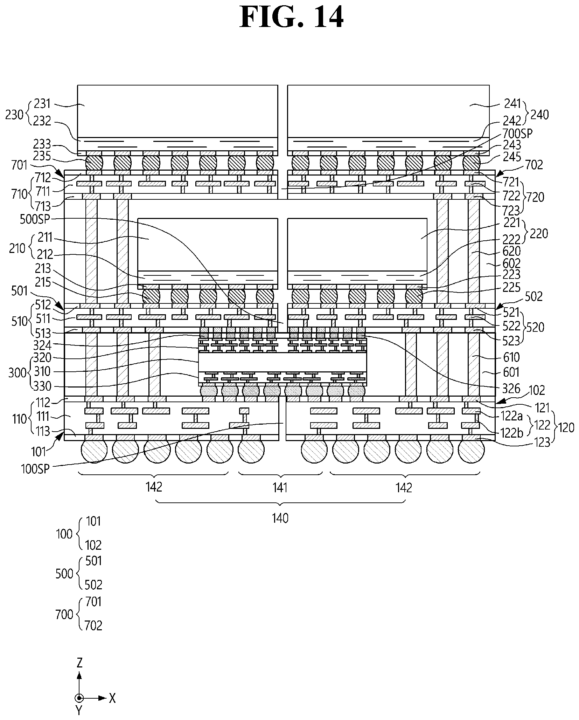

Referring to FIG. 14, the package substrate 100 may include a first sub-substrate 101 and a second sub-substrate 102. A third separation space 100SP may be placed between the first sub-substrate 101 and the second sub-substrate 102. The lower face of the first molding film 601 may be exposed to the third separation space 100SP.

The power balls 141 may be placed on the lower face of the first sub-substrate 101 and the lower face of the second sub-substrate 102.

The power of the first semiconductor chip 210 provided to the power ball 141 may be provided to the first semiconductor chip 210 through the package wiring structure 120 of the first sub-substrate 101, the power wiring structure 330, the first pillar structure 610, and the first sub-interposer 501.

The power of the second semiconductor chip 220 provided to the power ball 141 may be provided to the second semiconductor chip 220 through the package wiring structure 120 of the second sub-substrate 102, the power wiring structure 330, the first pillar structure 610, and the second sub-interposer 502.

The bridge die 300 may be placed over the first sub-substrate 101 and the second sub-substrate 102. The bridge die 300 may be placed to overlap a part of the first sub-substrate 101 and a part of the second sub-substrate 102. The power wiring structure 330 may be placed over the first sub-substrate 101 and the second sub-substrate 102.

A part of the bridge power bump 335 may be placed on the first sub-substrate 101. A part of the bridge power bump 335 may be connected to the package wiring structure 120 of the first sub-substrate 101. Another part of the bridge power bump 335 may be placed on the second sub-substrate 102. Still another part of the bridge power bump 335 may be connected to the package wiring structure 120 of the second sub-substrate 102.

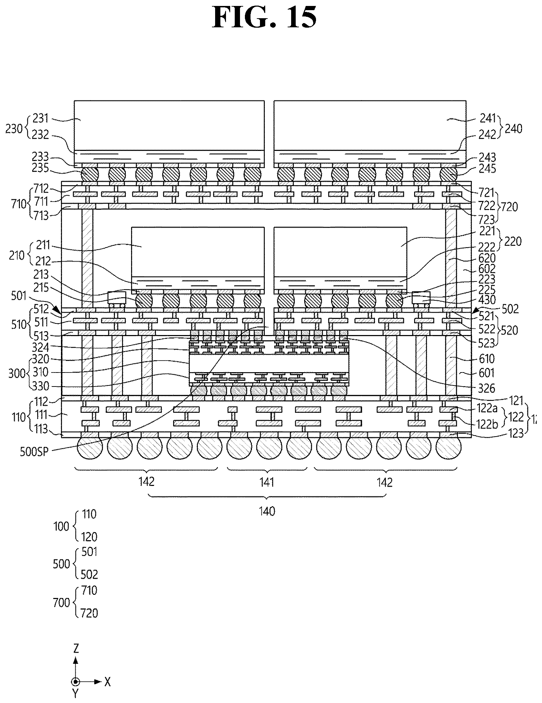

Referring to FIG. 15, one or more second passive elements 430 may be placed inside the second molding film 602. A second passive element 430 may be placed between the first semiconductor chip 210 and the second pillar structure 620. A second passive element 430 may be placed between the second semiconductor chip 220 and the second pillar structure 620. The second molding film 602 may cover the second passive element 430. The second passive element 430 may include, for example, an inductor. The second passive element(s) 430 may be used when power is provided from the power ball 141 to the first semiconductor chip 210 and the second semiconductor chip 220 through the power wiring structure 330.

Embodiments are set out in the following clauses:
Clause 1. A semiconductor package comprising:
   a package substrate;
   a first semiconductor chip on the package substrate, and includes a first power bump on a first lower face that faces the package substrate;
   a second semiconductor chip which is spaced apart from the first semiconductor chip on the package substrate, and includes a second power bump on a second lower face that faces the package substrate; and
   a bridge die below the first semiconductor chip and the second semiconductor chip on the package substrate, and connects the first semiconductor chip and the second semiconductor chip,
   wherein the bridge die includes,
      a connection wiring structure on a first face that faces the first semiconductor chip and the second semiconductor chip, and connects the first semiconductor chip and the second semiconductor chip,
      a power wiring structure on a second face that faces the package substrate, and is spaced apart from the connection wiring structure, and
      a substrate between the connection wiring structure and the power wiring structure,
      wherein the package substrate includes a power ball on a lower face of the package substrate and connected to the power wiring structure, and
      the power wiring structure is connected to the first power bump and the second power bump.
Clause 2. The semiconductor package of claim 1,
   wherein the first semiconductor chip further includes a first signal bump spaced apart from the first power bump, on the first lower face,
   the second semiconductor chip further includes a second signal bump spaced apart from the second power bump, on the second lower face,
   the package substrate further includes a signal ball on the lower face of the package substrate and spaced apart from the power ball, and
   the first signal bump and the second signal bump are connected to the signal ball.
Clause 3. The semiconductor package of clause 3, further comprising:
   a passive element between the power ball and the signal ball, on the lower face of the package substrate.
Clause 4. The semiconductor package of any preceding clause,
   wherein the power ball overlaps the bridge die.
Clause 5. The semiconductor package of any preceding clause, further comprising:
   an interposer on the package substrate,
   wherein the first semiconductor chip and the second semiconductor chip are on the interposer, and
   the bridge die is below the interposer.
Clause 6. The semiconductor package of clause 5,
   wherein the interposer includes,
   a first interposer, the first semiconductor chip on the first interposer, and
   a second interposer, spaced apart from the first interposer, and the second semiconductor chip on the second interposer, and
   the bridge die overlaps a part of the first interposer and a part of the second interposer.
Clause 7. A semiconductor package comprising:
   a package substrate;
   a first semiconductor chip on the package substrate, and includes a first power bump on a first lower face that faces the package substrate;
   a second semiconductor chip which is spaced apart from the first semiconductor chip on the package substrate, and includes a second power bump on a second lower face that faces the package substrate; and
   a bridge die below the first semiconductor chip and the second semiconductor chip on the package substrate, and connects the first semiconductor chip and the second semiconductor chip,
   wherein the bridge die includes,
      a connection wiring structure on a first face that faces the first semiconductor chip and the second semiconductor chip, and connects the first semiconductor chip and the second semiconductor chip,
      a connection bump between the connection wiring structure and the first semiconductor chip, and between the connection wiring structure and the second semiconductor chip,
      a power wiring structure on a second face that faces the package substrate, and is not connected to the connection wiring structure,
      a substrate between the connection wiring structure and the power wiring structure, and
      a third power bump between the power wiring structure and the package substrate;
      wherein the third power bump is connected to the first power bump and the second power bump, and
      a width of the bridge die is smaller than a width of the first semiconductor chip and a width of the second semiconductor chip.
Clause 8. An integrated circuit device comprising:
   a package substrate;
   a first semiconductor chip on the package substrate;
   a second semiconductor chip spaced apart from the first semiconductor chip on the package substrate; and
   a bridge die on the package substrate and between the first semiconductor chip and the second semiconductor chip,
   wherein the bridge die includes,
   a first face that faces the first semiconductor chip and the second semiconductor chip,
   a second face that faces the package substrate,
   a connection wiring structure on the first face, and connects the first semiconductor chip and the second semiconductor chip, and
   a power wiring structure on the second face, and is configured to supply power to the first semiconductor chip and the second semiconductor chip,
   wherein a level of signal provided to the connection wiring structure is smaller than a level of signal provided to the power wiring structure.
Clause 9. The integrated circuit device of clause 8,
   wherein the connection wiring structure and the power wiring structure are not connected.
Clause 10. The integrated circuit device of clause 8 or clause 9,
   wherein a width of the bridge die is smaller than a width of the first semiconductor chip and a width of the second semiconductor chip.
Clause 11. The integrated circuit device of any of clauses 8-10,
   wherein the first semiconductor chip includes a first power bump on a first lower face that faces the package substrate,
   the package substrate includes a power ball on a lower face of the package substrate, and
   the first semiconductor chip is provided with power through the power ball, the power wiring structure, and the first power bump.

In concluding the detailed description, those skilled in the art will appreciate that many variations and modifications may be made to the example embodiments without substantially departing from the principles of the present inventive concepts. Therefore, the disclosed example embodiments of the inventive concepts are used in a generic and descriptive sense only and not for purposes of limitation.

## Claims

1. A semiconductor package comprising:
a package substrate;
a first semiconductor chip on the package substrate;
a second semiconductor chip spaced apart from the first semiconductor chip on the package substrate; and
a bridge die placed below the first semiconductor chip and the second semiconductor chip on the package substrate,
wherein the bridge die includes,
a first face that faces the first semiconductor chip and the second semiconductor chip,
a second face that faces the package substrate,
a connection wiring structure on the first face, and connects the first semiconductor chip and the second semiconductor chip, and
a power wiring structure on the second face, and configured to provide power to the first semiconductor chip and the second semiconductor chip.

2. The semiconductor package of claim 1,
wherein the connection wiring structure and the power wiring structure are not connected.

3. The semiconductor package of claim 1 or claim 2,
wherein the bridge die further comprises a substrate between the first face and the second face, and
the connection wiring structure and the power wiring structure are spaced apart from each other with the substrate interposed therebetween.

4. The semiconductor package of any preceding claim,
wherein a width of the bridge die is smaller than a width of the first semiconductor chip and a width of the second semiconductor chip.

5. The semiconductor package of any preceding claim, further comprising:
a first chip bump between the first semiconductor chip and the package substrate;
a second chip bump between the second semiconductor chip and the package substrate; and
a power bump between the bridge die and the package substrate, and connected to the power wiring structure.

6. The semiconductor package of claim 5,
wherein a size of the first chip bump and a size of the second chip bump are greater than a size of the power bump.

7. The semiconductor package of claim 5 or claim 6,
wherein the package substrate includes a recess on an upper face that faces the second face of the bridge die, and
the power bump is inside the recess.

8. The semiconductor package of any of claims 1-4, further comprising:
an interposer on the package substrate,
wherein the first semiconductor chip and the second semiconductor chip are above the interposer, and
the bridge die is below the interposer.

9. The semiconductor package of claim 8, further comprising:
a pillar structure which extends between the interposer and the package substrate, and is spaced apart from the bridge die.

10. The semiconductor package of any preceding claim,
wherein the first semiconductor chip is a logic chip, and
the second semiconductor chip is a memory chip.

11. The semiconductor package of any preceding claim, further comprising:
a passive element on a lower face of the package substrate.

12. The semiconductor package of any preceding claim, further comprising:
a molding film between the package substrate and the first semiconductor chip, and between the package substrate and the second semiconductor chip, and surrounds a side face of the bridge die.

13. The semiconductor package of any preceding claim,
wherein the bridge die overlaps a part of the first semiconductor chip and a part of the second semiconductor chip.

14. A semiconductor package comprising:
a package substrate;
a first semiconductor chip on the package substrate, and includes a first power bump on a first lower face that faces the package substrate;
a second semiconductor chip which is spaced apart from the first semiconductor chip on the package substrate, and includes a second power bump on a second lower face that faces the package substrate; and
a bridge die below the first semiconductor chip and the second semiconductor chip on the package substrate, and connects the first semiconductor chip and the second semiconductor chip,
wherein the bridge die includes,
a connection wiring structure on a first face that faces the first semiconductor chip and the second semiconductor chip, and connects the first semiconductor chip and the second semiconductor chip,
a power wiring structure on a second face that faces the package substrate, and is spaced apart from the connection wiring structure, and
a substrate between the connection wiring structure and the power wiring structure,
wherein the package substrate includes a power ball on a lower face of the package substrate and connected to the power wiring structure, and
the power wiring structure is connected to the first power bump and the second power bump.

15. An integrated circuit device comprising:
a package substrate;
a first semiconductor chip on the package substrate;
a second semiconductor chip spaced apart from the first semiconductor chip on the package substrate; and
a bridge die on the package substrate and between the first semiconductor chip and the second semiconductor chip,
wherein the bridge die includes,
a first face that faces the first semiconductor chip and the second semiconductor chip,
a second face that faces the package substrate,
a connection wiring structure on the first face, and connects the first semiconductor chip and the second semiconductor chip, and
a power wiring structure on the second face, and is configured to supply power to the first semiconductor chip and the second semiconductor chip,
wherein a level of signal provided to the connection wiring structure is smaller than a level of signal provided to the power wiring structure.
